# EUROPEAN PATENT APPLICATION

(11) **EP 2 180 775 A1**
(43) Date of publication of application: **28.04.2010**
(21) Application number: 08253484.3
(22) Date of filing: 27.10.2008
(51) Int. Cl.: H05K 7/20

(54) **Equipment case**

(71) Applicant: BAE Systems PLC, 6 Carlton Gardens London SW1Y 5AD (GB)
(72) Inventor: The designation of the inventor has not yet been filed
(74) Representative: Thomas, Michael Andrew

(57) **Abstract**

An equipment case is provided. The case comprises a sealed housing unit configured to receive an item of equipment. Cooling means, associated with the housing unit, are provided for maintaining an operational thermal environment within the equipment case.

## Description

The present invention relates to the field of equipment cases, in particular, to controlling the environment within such an equipment case.

A conventional equipment case, housing and thereby protecting equipment such as a battlefield communications system, comprises a box having openings therein through which air can pass. Thus convection within the box is enhanced and cooling of the equipment is effected. Filters are placed in the openings to prevent (or at least inhibit) ingress of dust and/or fluid therethrough.

Such filters perform reasonably well when initially installed, permitting minimal levels of dust ingress, however they soon become clogged so that air flow therethrough is inhibited. Consequently, the filters need to be frequently maintained and cleaned or replaced at intervals if the thermal conditions within the equipment case are not to deteriorate rapidly such that overheating becomes a problem.

Even a small level of dust ingress serves to contaminate the equipment housed within the case. Such contamination is detrimental to the performance and service life of the equipment.

It is desirable to provide an equipment case having a reduced maintenance requirement, whilst maintaining or enhancing the level of protection for equipment contained therein.

According to a first aspect, the present invention provides a field equipment case comprising:
a sealed housing unit configured to receive an item of equipment; and
cooling means associated with the housing unit for maintaining an operational thermal environment within the equipment case.

By providing a sealed housing unit, ingress of moisture and particulate matter is inhibited. Consequently, deterioration in the performance and service life of the item of equipment housed within the equipment case is minimised.

The cooling system may be directly connected to the housing unit or it may be spaced from the housing unit but in fluid communication therewith.

The cooling system may comprise a first fan, mounted within the housing unit, and a second fan, mounted external to the housing unit. The first fan may be an axial fan. The second fan may be a centrifugal fan.

The cooling system may comprise a forced flow heat exchanger and it may be configured to establish a counter current thermal exchange mechanism between an internal fluid and an external fluid.

The present invention will now be described in more detail, by way of example only, in reference to the accompanying drawings in which:
Figure 1 illustrates an equipment case;
Figure 2 represents a cross section of Figure 1 on X-X, illustrating a cooling system;
Figure 3 illustrates a part of the cooling system internal to the equipment case;
Figure 4 illustrates a part of the cooling system external to the equipment case;
Figure 5 illustrates a comparison between a parallel flow and a counter flow thermal transfer system; and
Figure 6 illustrates a cross section, similar to that shown in Figure 2, of an alternative equipment case.

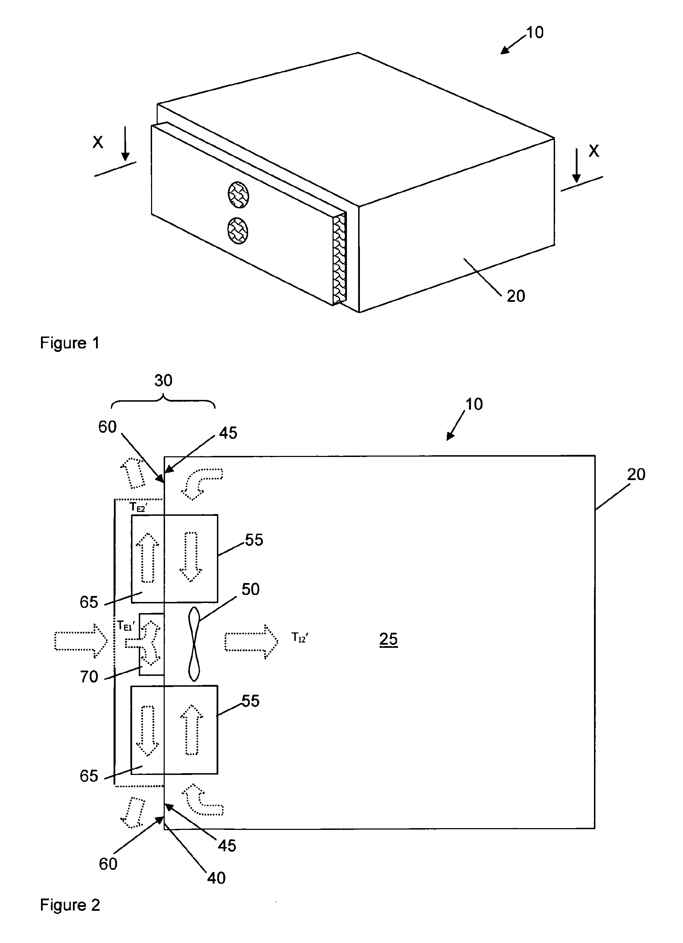

Figure 1 illustrates an equipment case 10. The dimensions of the case 10 are selected to accommodate a chosen type and model of equipment within the envelope described thereby. A housing unit 20 of the equipment case 10 defines a sealed cavity 25 for accommodating electronic equipment (not shown). Such an arrangement serves to inhibit the ingress of fluid and dust or other particulate matter into the equipment case 10 which could, potentially, damage the equipment protected thereby.

In one embodiment, the case is sealed to the extent that it is considered to be dust and weather proof to an IP rating of 65. In other words the unit is "totally protected from dust" and "protected from low pressure jets of water from all directions".

As a consequence, when used in hot environments (say in excess of 40°C) the internal thermal conditions of the equipment case 10 may be elevated. Equipment contained within the case 10 also, generally, generates heat and further contributes to the elevation of the internal temperatures.

By sealing the housing unit 20 a closed air loop is established, convection being the dominant mechanism of heat transfer used to cool the equipment.

Typically, electronic equipment contained in the case 10 ought not to exceed a threshold operating temperature of, say, 50°C. Thus it may be necessary to maintain a temperature difference of only 10°C between the environment internal to the equipment case 10 and the environment external to the equipment case 10.

The equipment case 10 is designed to minimise transmission of shock and vibrations experienced by the case 10 to equipment accommodated therewithin. For example, the equipment may be mounted within a frame, whereby the frame itself is connected to the housing unit 20 via shock suppression mounting brackets. Conduction of heat from the equipment to the housing unit 20 is, consequently minimal.

Electronic equipment installed within an equipment case 10 is, generally, both a source of and is susceptible to electromagnetic interference (EMI). In order to inhibit detection of the unit and to protect the unit from exposure to external electromagnetic interference, it is desirable to augment the electromagnetic shielding properties of the case 10. By eliminating any openings from the housing unit 20, enhanced electromagnetic shielding is achieved.

Figure 2 illustrates a cross section of the equipment case through line X-X such that a plan view of the case 10, as illustrated in Figure 1, is presented.

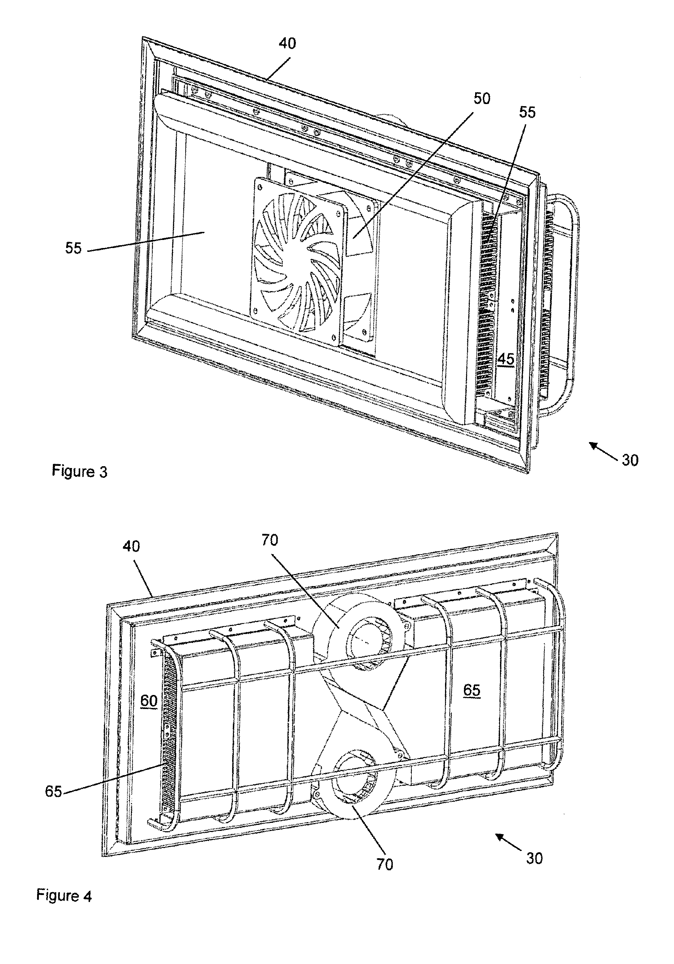

The equipment case 10 comprises a housing unit 20 coupled to a cooling system 30. The cooling system 30 comprises a number of components mounted on a wall 40 of the housing unit 20. An interior surface 45 of wall 40, namely that located inside the housing unit 20 of equipment case 10, is illustrated in Figure 3. An axial fan 50 is mounted on surface 45 together with a number of internal heat sinks 55. In the current embodiment, two internal heat sinks 55 are provided. The axial fan 50 is mounted centrally, between the two internal heat sinks 55 and is configured to draw air through the heat sinks 55 before redirecting the air stream into the cavity 25 of the equipment case 10.

Returning to Figure 2, in combination with Figure 4, an exterior surface 60 of wall 40 is presented. External heat sinks 65 are mounted on surface 60. The location of these external heat sinks 65 correspond to the internal heat sinks 55 mounted on internal surface 45. Wall 40 comprises a thermally conductive material such as a metal, to ensure that each external heat sink 65 is in thermal communication with a respective heat sink 55 located across the wall 40.

In this embodiment the wall 40 is made from aluminium, or an aluminium alloy, however other metals comprising copper or stainless steel may be used. Alternatively, the internal heat sinks 55 may achieve thermal communication with the corresponding external heat sinks 65 by using heat pipes or by direct contact with one another through an aperture formed in the wall 40. If the housing 20 comprising the wall 40 is made from a material heaving low thermal conductivity, e.g. carbon or glass fibre composite materials, a thermally conductive insert may be used locally between the internal and external heat sinks 55, 65 to provide a low resistance thermal path therebetween.

A corresponding number of centrifugal fans 70 (in this embodiment two) are also located on the exterior surface 60. Each centrifugal fan 70 is oriented such that ambient air drawn from the external environment is forced through the external heat sinks 65 as depicted in Figure 2 by the dotted arrows. Thus an air to air heat exchanger is provided. In an alternative embodiment, one or more axial fans (not shown) could replace the centrifugal fans 70.

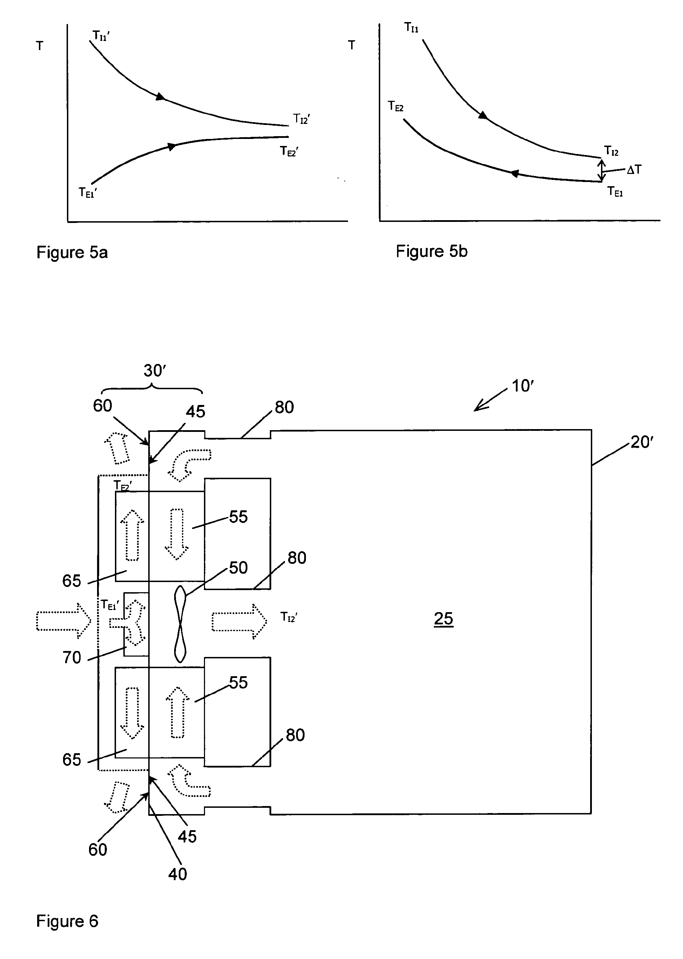

In operation, the airflow inside the housing unit 20 is drawn across heat sink 55 from an outer portion thereof to an inner portion thereof. In contrast, external to the housing unit 20 airflow is forced through heat sinks 65 from an interior portion thereof to an exterior portion thereof. Consequently, a counter current thermal exchange mechanism is established and heat transfer therebetween is consequently very efficient. Figure 5 illustrates the heat transfer mechanism in more detail.

In Figure 5a, a parallel system is shown whereby at one side of the combined heat sink a very significant thermal difference is illustrated (T_{I1}'-T_{E1}') however, at the other side of the heat sink a very small thermal difference is achieved (T_{I2}'-T_{E2}'). The coolest part of the interior T_{I2}' approaches the temperature of the hottest part of the exterior T_{E2}'.

In contrast, Figure 5b illustrates the counter current thermal exchange mechanism, whereby a more consistent thermal difference and, therefore thermal gradient, is achieved across the extent of the heat sinks 55, 65. In particular, the coolest part T_{I2} of the internal side 45 may reduce below the temperature T_{E2} of the hottest part of the external side 60. Consequently, a more efficient and greater level of heat transfer can be achieved.

In the illustrated embodiment, the internal and external heat sinks 55, 65 are located adjacent one another in direct thermal communication. Alternatively, the heat sinks 55, 65 could be spaced from one another and joined together using heat pipes.

As the equipment case 10 is a portable item it is necessary to achieve a lightweight configuration. Consequently, the heat sinks 55, 65 comprise lightweight compact heat exchange surfaces having a high surface area to volume ratio. Pin fins may be used as illustrated however, straight fins or foil fins are also appropriated and may be used. Alternatively, a metal, foam or other conductive material having a sufficiently large surface area to volume ratio could be used. A cover plate is provided over each respective heat sink 55, 65 so that fluid drawn or forced through the, or each, heat sink 55, 65 is constrained.

In an alternative embodiment, the equipment case 10' may comprise a housing unit 20' spaced from a cooling system 30' but in fluid and, therefore, thermal communication therewith. As depicted, the cooling system 30' is spaced from the housing unit 20' connected thereto via ducts 80. The cooling system 30' may be located on any face of the housing unit 20' as may prove convenient and the ducts 80 are configured accordingly.

In summary, thermally coupled internal and external forced flow heat exchangers are provided, whereby integrated fans provide forced convection cooling to internal equipment accommodated within a housing unit of the equipment case 10. In providing a forced flow heat exchange mechanism, the orientation of the equipment case becomes inconsequential as the cooling mechanism is unaffected thereby, unlike for natural convection. Additionally, the use of a counter flow exchange mechanism enhances performance such that operating conditions can be achieved for the electronic equipment even in particularly demanding thermal environments exceeding 40°C.

## Claims

1. A field equipment case comprising:
a sealed housing unit configured to receive an item of equipment; and
cooling means associated with the housing unit for maintaining an operational thermal environment within the equipment case.

2. A case according to Claim 1, wherein the cooling system is directly connected to the housing unit.

3. A case according to Claim 1, wherein the cooling system is spaced from the housing unit but in fluid communication therewith.

4. A case according to Claim 1 or Claim 2, wherein the cooling system comprises a first fan, mounted within the housing unit, and a second fan, mounted external to the housing unit.

5. A case according to Claim 4, wherein the first fan is an axial fan.

6. A case according to Claim 4 or Claim 5, wherein the second fan is a centrifugal fan.

7. A case according to any preceding claim, wherein the cooling system comprises a forced flow heat exchanger.

8. A case according to any preceding claim, wherein the cooling system is configured to establish a counter current thermal exchange mechanism between a fluid internal to the housing unit and a fluid external to the housing unit.
